# EUROPEAN PATENT SPECIFICATION

(11) **EP 2 055 728 B1**
(45) Date of publication and mention of the grant of the patent: **04.08.2010**
(21) Application number: 08018804.8
(22) Date of filing: 28.10.2008
(51) Int. Cl.: C08G 59/40, C08G 73/06, C08G 73/16

(54) **Resin composition, prepreg and laminate using the same**
Harzzusammensetzung, Prepreg und Laminat damit hergestellt
Composition de résine, pré-imprégné et stratifié l'utilisant

(30) Priority: 29.10.2007 JP 2007280266; 30.10.2007 JP 2007281217; 30.10.2007 JP 2007281218
(43) Date of publication of application: 06.05.2009
(73) Proprietor: Mitsubishi Gas Chemical Company, Inc., Chiyoda-ku Tokyo (JP)
(72) Inventor: Nishimura, Yoshimasa, Niigata-shi Niigata-ken (JP); Sogame, Masanobu, Tokyo (JP); Fukuoka, Hironao, Tokyo (JP); Sugano, Yuuichi, Niigata-shi Niigata-ken (JP); Katagiri, Masayuki, Niigata-shi Niigata-ken (JP)
(74) Representative: Adam, Holger

(56) References cited:
- JP-A- 9 100 393
- US-A- 3 803 088
- KORSHAK V V ET AL: "Synthesis and investigation of aryl dicyanate copolymers" POLYMER SCIENCE U.S.S.R, PERGAMON, vol. 17, no. 1, 1 January 1975 (1975-01-01), pages 24-30, XP024127001 ISSN: 0032-3950 [retrieved on 1975-01-01]

## Description

### Field of the Invention

The present invention relates to a resin composition suitably used for a printed wiring board where an electric circuit is to be formed, and a prepreg and a laminate each of which uses the above resin composition.

### Background of the Invention

A cyanate ester resin has been known as a thermosetting resin excellent in heat resistance after moisture absorption and dielectric characteristics. A resin composition containing a bisphenol A type cyanate ester resin and other thermosetting resin or thermoplastic resin has been disclosed (for example, JP-B2-54-30440). Such resin compositions have excellent properties in terms of electric properties, mechanical properties, chemical resistance and adhesive properties. Therefore, on the basis of these technologies, such resin compositions are widely used for materials for high-function printed wiring boards for use in semiconductor plastic packages in recent years. However, the bisphenol A type cyanate ester resin is insufficient in heat resistance under severe conditions in some cases so that studies on cyanate ester resins having other structures have been conducted. Moreover, in accordance with a recent demand for reduction in size and weight of electric parts, further improvements of a resin composition as a raw material are demanded in mechanical properties such as heat resistance or elastic modulus.

Further, flame retardancy is generally necessary to a resin composition for printed wiring boards. Generally, a bromine flame retardant is jointly incorporated (for example, JP-A-11-021452). However, a resin composition containing no halogen compound is desired in accordance with a recent growing interest in environmental issues. In addition, with regard to the bisphenol A type cyanate ester resin, it is required that an inorganic filling material in an amount larger than normal is incorporated for satisfying the requirement of flame retardancy. Through the influence thereof, there is a problem about moldability and a limitation is imposed on an improvement in the appearance of a substrate.

For overcoming these problems, resin compositions based on the cyanate ester resins having other structures have been studied. A novolak type cyanate ester resin is broadly known as a cyanate ester resin excellent in heat resistance and flame retardancy (for example, JP-A-11-124433). However, the novolak type cyanate ester resin is apt to be insufficient in curing degree under normal curing conditions. A cured product obtained therefrom has a large water absorption coefficient and decreases in heat resistance after moisture absorption. As means for improving the novolak type cyanate ester resin, a co-prepolymer thereof with a bisphenol A type cyanate ester resin is disclosed (for example, JP-A-2000-191776). Although the above co-prepolymer is improved in curability, it is still insufficient in terms of improvements in properties. Therefore, there is a strong demand for a cyanate ester resin composition which not only has heat resistance and heat resistance after moisture absorption but also secures flame retardancy without the use of a halogenous flame retardant.

### Summary of the Invention

It is an object of the present invention to provide a cyanate ester resin composition for a printed wiring board material which composition is improved in heat resistance and heat resistance after moisture absorption, is excellent in mechanical properties such as elastic modulus and has flame retardancy without a halogen compound and to provide a prepreg and a laminate each of which uses the above resin composition.

The present inventors have found that a resin composition having high curability, excellent heat resistance and excellent heat resistance after moisture absorption can be obtained by incorporating an epoxy resin into a cyanate ester resin having a specific structure. In particular, the present inventors have found that the incorporation of a non-halogen epoxy resin and an inorganic filler gives a halogen-free resin composition having flame retardancy. Further, the present inventors have found that a thermosetting resin composition excellent in heat resistance and elastic modulus can be obtained by jointly incorporating a maleimide compound into the cyanate ester resin having a specific structure. On the basis of these findings, the present inventors have completed the present invention.

The present invention provides a resin composition containing a cyanate ester resin component A comprising a cyanate ester compound represented by the formula (1) and/or an oligomer thereof, and at least one component B selected from the group consisting of an epoxy resin and a maleimide compound.

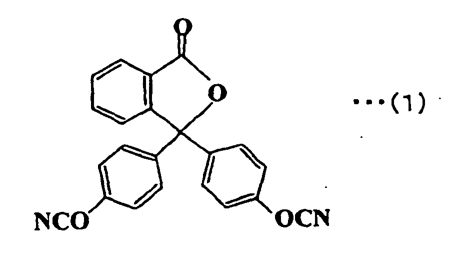

The present invention further provides a resin composition according to the above which further contains an inorganic filler and a cured product obtained by curing the above resin composition.

The present invention furthermore provides a resin composition containing a cyanate ester resin component A comprising a cyanate ester compound represented by the above formula (1) and/or an oligomer thereof, and a component B comprising an epoxy resin or an epoxy resin and a maleimide compound. The present invention still further provides a resin composition according to the above which further contains an inorganic filler, a resin composition according to the above wherein the epoxy resin is a non-halogen epoxy resin, a prepreg comprising the above resin composition and a base material, a laminate comprising the above prepreg and a metal-foil-clad laminate obtained by using the above prepreg.

### Effect of the Invention

The resin composition provided by the present invention is excellent in heat resistance and flame retardancy owing to the stiff skeleton structure of the specific cyanate ester resin. In addition, the resin composition of the present invention is increased in curability since the incorporation of the epoxy resin and/or the bismaleimide compound reduces reaction inhibition factors which are based on the molecular structure, etc., of cyanate ester resin. Accordingly, the resin composition of the present invention has excellent heat resistance after moisture absorption and high elastic modulus. Further, the laminate or the metal-foil-clad laminate obtained by curing the prepreg of the present invention is suitable for a high-density-support printed wiring board material. The industrial practicality of the present invention is remarkably high.

### Detailed Description of the Invention

The component A used in the present invention refers to a cyanate ester resin comprising a cyanate ester compound represented by the formula (1) and/or an oligomer thereof. The cyanate ester compound represented by the formula (1) is obtained by condensation of 3,3-bis(4-hydroxyphenyl)-1(3H)-isobenzofuranone and a cyanic acid. The method of producing the cyanate ester compound represented by the formula (1) is not specially limited. Any known cyanate ester synthesis method can be employed for its production. Specifically, for example, it is obtained by reacting 3, 3-bis(4-hydroxyphenyl)-1(3H)-isobenzofuranone and a cyanogen halide in an inactive organic solvent in the presence of a basic compound. The oligomer of the cyanate ester compound represented by the formula (1) can be, for example, obtained by melting the cyanate ester compound of the formula (1) at a temperature of from 140 to 160 °C and reacting cyanate ester groups with stirring.

The component B used in the present invention refers to a compound which comprises an epoxy resin and/or a maleimide compound and can be reacted with cyanate ester groups.

The epoxy resin used as the component B is not specially limited so long as it is a compound having at least two epoxy groups. Examples thereof include a bisphenol A type epoxy resin, a bisphenol F type epoxy resin, a phenol novolak type epoxy resin, a cresol novolak type epoxy resin, a bisphenol A novolak type epoxy resin, a brominated bisphenol A type epoxy resin, a brominated phenol novolak type epoxy resin, a trifunctional phenol type epoxy resin, a tetrafunctional phenol type epoxy resin, a naphthalene type epoxy resin, a biphenyl type epoxy resin, a phenol aralkyl type epoxy resin, a biphenyl aralkyl type epoxy resin, a naphthol aralkyl type epoxy resin, an alicyclic epoxy resin, a polyol type epoxy resin, a phosphorus-containing epoxy resin, glycidyl amine, glycidyl ester, a compound obtained by epoxidation of a double bond of butadiene or the like, and a compound obtained by a reaction of a hydroxyl-group-containing silicon resin with epichlorohydrin. The above epoxy resin is preferably a bisphenol A type epoxy resin, a bisphenol F type epoxy resin, a phenol novolak type epoxy resin, a cresol novolak type epoxy resin, a bisphenol A novolak type epoxy resin, a brominated bisphenol A type epoxy resin, a brominated phenol novolak type epoxy resin, a biphenyl type epoxy resin, a phenol aralkyl type epoxy resin, a biphenyl aralkyl type epoxy resin or a naphthol aralkyl type epoxy resin. The epoxy resin can be used alone or at least two epoxy resins can be used in combination as required.

Further, the resin composition can become a halogen-free resin composition by using as the epoxy resin a non-halogen epoxy resin which intentionally does not have a halogen atom in a molecule. The non-halogen epoxy resin is not specially limited. Examples thereof include a bisphenol A type epoxy resin, a bisphenol F type epoxy resin, a phenol novolak type epoxy resin, a cresol novolak type epoxy resin, a bisphenol A novolak type epoxy resin, a trifunctional phenol type epoxy resin, a tetrafunctional phenol type epoxy resin, a naphthalene type epoxy resin, a biphenyl type epoxy resin, a phenol aralkyl type epoxy resin, a biphenyl aralkyl type epoxy resin, a naphthol aralkyl type epoxy resin, an alicyclic epoxy resin, a polyol type epoxy resin, a phosphorus-containing epoxy resin, glycidyl amine, glycidyl ester, a compound obtained by epoxidation of a double bond of butadiene or the like, and a compound obtained by a reaction of a hydroxyl-group-containing silicon resin with epichlorohydrin. The above non-halogen epoxy resin is preferably a phenol novolak type epoxy resin, a biphenyl type epoxy resin, a phenol aralkyl type epoxy resin, a biphenyl aralkyl type epoxy resin or a naphthol aralkyl type epoxy resin. The non-halogen epoxy resin can be used alone or at least two non-halogen epoxy resins can be used in combination as required.

When the epoxy resin is used as the component B, the mixing ratio between the component A and the epoxy resin is not specially limited. The weight ratio of component A : epoxy resin is preferably in the range of from 10 : 90 to 90 : 10, particularly preferably from 30 : 70 to 70 : 30. When the non-halogen epoxy resin is used as the epoxy resin, the above weight ratio range is also preferred. When the amount of the component A is too small, a laminate obtained decreases in heat resistance. When it is too large, solvent solubility or curability decreases.

The maleimide compound used as the component B is not specially limited so long as it is a compound having at least two maleimide groups in a molecule. Specific examples thereof include bis(4-maleimidophenyl)methane, 2,2-bis{4-(4-maleimidophenoxy)phenyl}propane, bis(3,5-dimethyl-4-maleimidophenyl)methane, bis(3-ethyl-5-methyl-4-maleimidophenyl)methane, bis(3,5-diethyl-4-maleimidophenyl)methane, polyphenyl methane maleimide, prepolymers of these maleimide compounds, and a prepolymer of one of these maleimide compounds and an amine compound. The maleimide compound can be used alone or at least two maleimide compounds can be used in combination as required. The maleimide compound is more preferably bis(4-maleimidophenyl)methane, 2,2-bis{4-(4-maleimidophenoxy)phenyl}propane or bis(3-ethyl-5-methyl-4-maleimidophenyl)methane.

When the maleimide compound is used as the component B, the mixing ratio between the component A and the maleimide compound is not specially limited. The weight ratio of component A : maleimide compound is preferably in the range of from 25 : 75 to 95 : 5, particularly preferably from 30 : 70 to 90 : 10. When the amount of the component A is too small, a laminate obtained decreases in properties after moisture absorption. When it is too large, bending strength or heat resistance is decreased.

When the epoxy resin and the maleimide compound are used in combination as the component B, reaction inhibition factors, which are based on the molecular structure, etc., of a cyanate ester resin, are reduced so that the resin composition is improved in curability and excellent effects are shown in terms of heat resistance after moisture absorption and heat resistance. Therefore, it is preferred to use the epoxy resin and the maleimide compound in combination.

The inorganic filler used in the present invention is not specially limited so long as it is selected from generally-used inorganic fillers. Specific examples thereof include silicas such as natural silica, fused silica, amorphous silica and hollow silica, metal hydroxides such as aluminum hydroxide, a heat-treated product of aluminum hydroxide (obtained by heat-treating aluminum hydroxide and decreasing crystal water partially), boehmite and magnesium hydroxide, molybdenum compounds such as molybdenum oxide and zinc molybdate, zinc borate, zinc stannate, alumina, clay, kaolin, talc, calcined clay, calcined kaolin, calcined talc, mica, short glass fiber (fine powders of glasses such as E glass or D glass) and hollow glass. The average particle diameter of the inorganic filler is 0.1 to 10 µm, preferably 0.2 to 5 µm. The inorganic fillers which are different from each other in terms of particle size distribution and/or average particle diameter can be used in combination as required. The amount of the inorganic filler is not specially limited. It is preferably 10 to 300 parts by weight, particularly preferably 30 to 200, per 100 parts by weight of the total amount of the component A and the component B.

A silane-coupling agent or a wetting and dispersing agent can be jointly used with the above inorganic filler used in the present invention. The silane-coupling agent is not specially limited so long as it is selected from silane coupling agents which are generally used for surface-treating inorganic substances. Specific examples thereof include aminosilane coupling agents such as γ-aminopropyltriethoxysilane and N-β-(aminoethyl)-γ-aminopropyltrimethoxysilane, epoxysilane coupling agents such as γ-glycidoxypropyltrimethoxysilane, vinylsilane coupling agents such as γ-methacryloxypropyltrimethoxysilane, cationic silane coupling agents such as N-β-(N-vinylbenzylaminoethyl)-γ-aminopropyltrimethoxysilane hydrochloride and phenylsilane coupling agents. The silane coupling agent can be used singly or at least two silane coupling agents can be used in combination, as required. The wetting and dispersing agent is not specially limited so long as it is selected from dispersion stabilizers which are used for coatings. For example, copolymer-based wetting and dispersing agents having an acid group such as Disperbyk-110, 111, 996 and W903 supplied by Big Chemie Japan can be used.

A curing accelerator can be jointly incorporated into the resin composition of the present invention, as required, for the purpose of properly controlling the curing speed. The curing accelerator is not specially limited so long as it is selected from curing accelerators which are generally used for a cyanate ester resin, an epoxy resin or a maleimide compound. Specific examples of the curing accelerator, which is to be used when the component B is the epoxy resin, include salts of organic metals such as copper, zinc, cobalt and nickel, imidazoles and derivatives thereof, and tertiary amines. Specific examples of the curing accelerator, which is to be used when the component B is the maleimide compound, include organic peroxides such as benzoyl peroxide, lauroyl peroxide, acetyl peroxide, parachlorobenzoyl peroxide and di-tert-butyl-di-perphthalate; azo compounds such as azobisnitrile; imidazoles such as 2-methylimidazole, 2-undecylimidazole, 2-phenylimidazole, 2-ethyl-4-methylimidazole, 1-benzyl-methylimidazole, 1-cyanoethyl-2-methylimidazole, 1-cyanoethyl-2-ethylimidazole, 1-cyanoethyl-2-undecylimidazole, 1-cyanoethyl-2-phenylimidazole, 1-cyanoethyl-2-ethyl-methylimidazole, 1-guanaminoethyl-2-methylimidazole, carboxylic acid adducts of these imidazoles and carboxylic anhydride adducts of these imidazoles; tertiary amines such as N,N-dimethylbenzylamine, N,N-dimethylaniline, N,N-dimethyltoluidine, 2-N-ethylanilinoethanol, tri-n-butylamine, pyridine, quinoline, N-methylmorpholine, triethanolamine, triethylenediamine, tetramethylbutanediamine and N-methylpiperidine; phenols such as phenol, xylenol, cresol, resorcin and catechol; organic metal salts such as lead naphthenate, lead stearate, zinc naphthenate, zinc octylate, tin oleate, dibutyltin maleate, manganese naphthenate, cobalt naphthenate and acetylacetone iron; a substance obtained by dissolving any one of these organic metal salts in a hydroxyl-group-containing compound such as phenol or bisphenol; inorganic metal salts such as tin chloride, zinc chloride and aluminum chloride; and organotin compounds such as dioctyltin oxide, other alkyltin and alkyltin oxide. The curing accelerator may be added in an ordinary amount. For example, the amount of the curing accelerator is 10 wt% or less, generally about 0.01 to 2 wt%, based on the resin composition.

The resin composition of the present invention may further contain a cyanate ester resin other than the cyanate ester compound represented by the formula (1). The above cyanate ester resin other than the cyanate ester compound represented by the formula (1) can be selected from known cyanate ester resins. Example thereof include a bisphenol A type cyanate ester resin, a bisphenol F type cyanate ester resin, a bisphenol M type cyanate ester resin, a bisphenol P type cyanate ester resin, a bisphenol E type cyanate ester resin, a phenol novolak type cyanate ester resin, a cresol novolak type cyanate ester resin, a dicyclopentadiene novolak type cyanate ester resin, a tetramethyl bisphenol F type cyanate ester resin, a biphenol type cyanate ester resin, a phenol aralkyl type cyanate ester resin, a xylenol aralkyl type cyanate ester resin, a naphthol aralkyl type cyanate ester resin and oligomers of these. The cyanate ester resin other than the cyanate ester compound represented by the formula (1) can be used alone or at least two cyanate ester resins other than the cyanate ester compound represented by the formula (1) can be used in combination, as required.

The resin composition of the present invention can jointly contain a variety of high polymer compounds such as a different thermosetting resin, a thermoplastic resin and oligomers thereof, and elastomers, a different flame retardant compound or an additive, so long as the inherent properties of the resin composition are not impaired. They are not specially limited so long as they are selected from those which are generally used. Examples of the flame retardant compound include phosphorus compounds such as a phosphoric acid ester or a phosphoric acid melamine, a nitrogen-containing compound such as melamine or benzoguanamine, an oxazine-ring-containing compound and a silicone compound. Examples of the resins include polyimide, polyvinyl acetal, a phenoxy resin, an acrylic resin, an acrylic resin having a hydroxyl group or a carboxylic group, an alkyd resin, a thermoplastic polyurethane resin; elastomers such as polybutadiene, a butadiene-acrylonitrile copolymer, polychloroprene, a butadiene-styrene copolymer, polyisoprene, butyl rubber, fluoro rubber and natural rubber; vinyl compound polymers such as styrene-isoprene rubber, acrylic rubber, core shell rubbers of these, epoxidized butadiene, maleated butadiene, polyethylene, polypropylene, a polyethylene-propylene copolymer, poly-4-methylpentene-1, polyvinyl chloride, polyvinylidene chloride, polystyrene, polyvinyl toluene, polyvinyl phenol, an AS resin, an ABS resin, an MBS resin, poly-4-fluoroethylene, a fluoroethylene-propylene copolymer, 4-fluoroethylene-6-fluoroethylene copolymer and vinylidene fluoride; thermoplastic resins and low-molecular-weight polymers thereof such as polycarbonate, polyester carbonate, polyphenylene ether, polysulfone, polyester, polyether sulfone, polyamide, polyamide imide, polyester imide and polyphenylene sulfite; polyallyl compounds and prepolymers thereof such as poly(meth)acrylates, such as (meth)acrylate, epoxy(meth)acrylate and di(meth)acryloxy-bisphenol, styrene, vinylpyrrolidone, diacryl phthalate, divinylbenzene, diallyl benzene, diallyl ether bisphenol and triallyl isocyanurate; and curable monomers or prepolymers such as dicyclopentadiene and prepolymers thereof, a phenolic resin, polymerizable-double-bond-containing monomers and prepolymers thereof, such as an unsaturated polyester, and polyisocyanates. Examples of the additive include an ultraviolet absorber, an antioxidant, a photopolymerization initiator, a fluorescent brightening agent, a photosensitizer, a dye, a pigment, a thickener, a lubricant, an antifoamer, a dispersing agent, a leveling agent, a brightener and a polymerization inhibitor. These additives may be used in combination as required.

The method of mixing the resin composition containing the component A and the component B in the present invention is not specially limited. For example, it is possible to simply melt-blend the component A and the component B. It is also possible to dissolve the component A and the component B in an organic solvent and blend them. Furthermore, the component A and the component B can be blended after one or two selected from the component A and the component B is/are converted into oligomer(s). Otherwise, it is also possible to blend two or three selected from the component A and the component B and then convert them into oligomers.

An organic solvent can be used in the resin composition of the present invention as required. The organic solvent is not specially limited so long as the organic solvent can dissolve a mixture of the component A and the component B. Specific example thereof include ketones such as such as acetone, methyl ethyl ketone, methyl isobutyl ketone and cyclohexanone, aromatic hydrocarbons such as benzene, toluene and xylene, amides such as dimethylformamide and dimethylacetamide.

The resin composition of the present invention is cured alone, whereby a cured product can be obtained. Further, the resin composition of the present invention is impregnated into a base material, whereby a prepreg which is applicable to a laminate or a metal-foil-clad laminate can be obtained.

The base material suitably used in the present invention can be selected from known base materials which are used for a variety of printed wiring boards. Examples of the base material include fibers of glasses such as E glass, D glass, S glass, NE glass, T glass and quartz, inorganic fibers such as a carbon fiber, an alumina fiber, a silicon carbide fiber, asbestos, rock wool, slag wool and plaster whisker, and organic fibers such as polyimide, polyamide, polyester, a fluorine fiber, a polybenzoxazole fiber, cotton, linen and a semi-carbon fiber. The base material is selected in accordance with an intended use or performance, as required. The base material can be used alone or at least two base materials can be used in combination. The form of the base material is typically a woven fabric, a nonwoven fabric, roving, a chopped strand mat or a surfacing mat. The thickness thereof is not specially limited. The thickness thereof is generally approximately 0.01 to 0.3 mm. Further, a base material having been surface-treated with a silane-coupling agent or the like and a woven fabric having been physically opened can be preferably used in view of heat resistance after moisture absorption. Further, a film made of polyimide, polyamide, polyester or the like can be used as the base material. The thickness of the film is not specially limited. It is preferably approximately 0.002 to 0.05 mm. A film having been surface-treated by means of plasma treatment or the like is more preferred.

The method of producing the prepreg of the present invention is not specially limited so long as the prepreg is produced by combining the resin composition containing the component A and the component B with the base material. In one example of such method, for instance, the above resin composition is impregnated into or applied to the base material and then the resin composition is semi-cured by heating the resultant base material in a drying machine at 100 to 200 °C for 1 to 60 minutes or by other procedure, thereby producing the prepreg. The content of the resin composition, which may contain the inorganic filler, in the prepreg is preferably 20 to 95 % by weight.

The laminate and metal-foil-clad laminate provided by the present invention are obtained by carrying out laminate-molding using the aforesaid prepreg. Specifically, the laminate or metal-foil-clad laminate is produced by providing one prepreg mentioned above or stacking two or more prepregs, disposing a metal foil such as copper or aluminum on one surface or both surfaces of the prepreg or the stack of the prepregs, as required, and laminate-molding the resultant set. The metal foil is not specially limited so long as it is selected from metal foils which are generally used as a printed wiring board material. General technical skills for laminates and multilayer boards for printed wiring boards can be adopted with regard to molding conditions. For example, a multiplaten press, a multiplaten vacuum press, continuous molding, an autoclave molding machine or the like is generally used. The temperature is generally 100 to 300 °C. The pressure is generally 2 to 100 kgf/cm². The heating time is generally 0.05 to 5 hours. Further, a multilayer board can be produced by combining the prepreg of the present invention and a wiring board, prepared separately, for an internal layer and laminate-molding the prepreg and the wiring board.

### Examples

### (Synthetic Example 1) Synthesis of 3,3-bis(4-cyanatophenyl)- 1(3H)-isobenzofuranone

2.04 mol of 3,3-bis(4-hydroxyphenyl)-1(3H)-isobenzofuranone (supplied by Hachidai Pharmaceutical Co., LTD.) and 4.49 mol of triethylamine were dissolved in 3,250 g of methylene chloride to prepare a solution 1. The solution 1 was dropwise added to 1,462.45 g of a methylene chloride solution containing 5.51 mol of cyanogen chloride dissolved therein at -10 °C over 3 hours. The mixture was stirred for 30 minutes. Then, 0.20 mol of triethylamine was dropwise added. The mixture was further stirred for 30 minutes, to complete the reaction. The thus-obtained solution was washed with 3, 000 mL of 0.1 N hydrochloric acid. Then, washing with 1, 000 mL of water was repeated four times. The washed solution was concentrated and then cooled to obtain a yellowish white crystal. The crystal was washed with 2,000 mL of n-hexane and then dried under a reduced pressure, to obtain 677 g of a white crystal of 3,3-bis(4-cyanatophenyl)-1(3H)-isobenzofuranone. The thus-obtained cyanate ester compound was subjected to an infrared absorption spectrum measurement. From the results of the measurement, it was confirmed that the absorption of a phenolic OH group at 3,200 - 3600cm⁻¹ disappeared and an absorption was present around 2264 cm⁻¹ corresponding to the absorption of a nitrile of cyanate ester. The melting point was 130 °C.

### (Example 1)

70 parts by weight of 3,3-bis(4-cyanatophenyl)-1 (3H)-isobenzofuranone obtained in Synthetic Example 1 and 30 parts by weight of bis(4-maleimidophenyl)methane (BMI-H, supplied by K I KASEI KK) were melt-blended at 160 °C for 10 minutes. The melt-blended mixture was poured into a casting mold and defoamed under vacuum at 165 °C for 15 minutes. Then it was cured under heat at 180 °C for 4 hours, at 200 °C for 4 hours, and at 250 °C for 4 hours, thereby obtaining a cured product having a thickness of 3 mm and a cured product having a thickness of 2 mm. Table 1 shows the results of measurements of physical properties of the cured products.

### (Comparative Example 1)

A cured product having a thickness of 3 mm and a cured product having a thickness of 2 mm were obtained in the same manner as in Example 1 except that 70 parts by weight of 3,3-bis(4-cyanatophenyl)-1(3H)-isobenzofuranone used in Example 1 was replaced with 70 parts by weight of 2,2-bis(4-cyanatophenyl)propane (CX, supplied by Mitsubishi Gas Chemical Company, Inc.). Table 1 shows the results of measurements of physical properties of the cured products.

### (Comparative Example 2)

A cured product having a thickness of 3 mm and a cured product having a thickness of 2 mm were obtained in the same manner as in Example 1 except that 70 parts by weight of 3,3-bis(4-cyanatophenyl)-1(3H)-isobenzofuranone used in Example 1 was replaced with 70 parts by weight of a phenol novolak type cyanate ester resin (Primaset PT-30, supplied by LONZA). Table 1 shows the results of measurements of physical properties of the cured products.

### (Comparative Example 3)

3,3-bis(4-cyanatophenyl)-1(3H)-isobenzofuranone obtained in Synthetic Example 1 was molten at 160 °C for 10 minutes, then poured into a casting mold and defoamed under vacuum at 165 °C for 15 minutes. Then it was cured under heat at 180 °C for 4 hours, at 200 °C for 4 hours, and at 250 °C for 4 hours, thereby obtaining a cured product having a thickness of 3 mm and a cured product having a thickness of 2 mm. Table 1 shows the results of measurements of physical properties of the cured products. In the above measurements, the measurement of a glass transition temperature was impossible. The glass transition temperature was uneven, probably because the degree of curing was insufficient because of reaction inhibition factors based on the molecular structure, etc., of cyanate ester resin.

### (Example 2)

50 parts by weight of 3,3-bis(4-cyanatophenyl)-1(3H)-isobenzofuranone obtained in Synthetic Example 1 and 50 parts by weight of bis (4-maleimidophenyl)methane (BMI-H) were melt-blended at 160 °C for 10 minutes. The melt-blended mixture was poured into a casting mold and defoamed under vacuum at 165 °C for 15 minutes. Then it was cured under heat at 180 °C for 4 hours, at 200 °C for 4 hours, and at 250 °C for 4 hours, thereby obtaining a cured product having a thickness of 3 mm and a cured product having a thickness of 2 mm. Table 2 shows the results of measurements of physical properties of the cured products.

### (Comparative Example 4)

A cured product having a thickness of 3 mm and a cured product having a thickness of 2 mm were obtained in the same manner as in Example 2 except that 50 parts by weight of 3,3-bis(4-cyanatophenyl)-1(3H)-isobenzofuranone used in Example 2 was replaced with 50 parts by weight of 2,2-bis(4-cyanatophenyl)propane (CX, supplied by Mitsubishi Gas Chemical Company, Inc.). Table 2 shows the results of measurements of physical properties of the cured products.

### (Comparative Example 5)

A cured product having a thickness of 3 mm and a cured product having a thickness of 2 mm were obtained in the same manner as in Example 2 except that 50 parts by weight of 3,3-bis(4-cyanatophenyl)-1(3H)-isobenzofuranone used in Example 2 was replaced with 50 parts by weight of a phenol novolak type cyanate ester resin (Primaset PT-30, supplied by LONZA). Table 2 shows the results of measurements of physical properties of the cured products.

**Table 1**

| (Table 1) | Example 1 | Comparative Example 1 | Comparative Example 2 | Comparative Example 3 |
|---|---|---|---|---|
| Glass transition temperature (°C) | 270 | 261 | 259 | Impossible to measure |
| Bending elastic modulus (GPa) | 5.2 | 3.6 g | 9.9 | 4.3 |

**Table 2**

| (Table 2) | Example 2 | Comparative Example 4 | Comparative Example 5 |
|---|---|---|---|
| Glass transition temperature (°C) | 273 | 266 | 251 |
| Bending elastic modulus (GPa) | 5.2 | 3.9 g | 4.9 |

### (Example 3)

45 parts by weight of 3,3-bis(4-cyanatophenyl)-1 (3H)-isobenzofuranone obtained in Synthetic Example 1 and 55 parts by weight of a cresol novolak type epoxy resin (ESCN-220F, supplied by Sumitomo Chemical Co. Ltd.) were dissolved in methyl ethyl ketone. 0.04 part by weight of zinc octylate was mixed with the resultant solution to obtain a varnish. The varnish was diluted with methyl ethyl ketone. The diluted varnish was impregnated into an E glass cloth having a thickness of 0.1 mm. The impregnated varnish was dried under heat at 165 °C for 6 minutes, thereby obtaining prepregs having a resin content of 39 % by weight. Four prepregs obtained above were stacked and 18µm-thick electrolytic copper foils were placed on the upper and lower surfaces of the stack of the prepregs, one copper foil on the upper surface and one copper foil on the lower surface, and the prepregs and the copper foils were pressed at a pressure of 30 kgf/cm² at a temperature of 220 °C for 120 minutes, thereby obtaining a copper-clad laminate having a thickness of 0.4 mm. Table 3 shows the results of measurements of physical properties of the copper-clad laminate.

### (Comparative Example 6)

A copper-clad laminate having a thickness of 0.4 mm was obtained in the same manner as in Example 3 except that 45 parts by weight of 3,3-bis(4-cyanatophenyl)-1(3H)-isobenzofuranone used in Example 3 was replaced with 45 parts by weight of a prepolymer of 2,2-bis(4-cyanatophenyl)propane (BT2070, supplied by Mitsubishi Gas Chemical Company, Inc.). Table 3 shows the results of measurements of physical properties of the copper-clad laminate.

### (Comparative Example 7)

A copper-clad laminate having a thickness of 0.4 mm was obtained in the same manner as in Example 3 except that 45 parts by weight of 3,3-bis(4-cyanatophenyl)-1(3H)-isobenzofuranone used in Example 3 was replaced with 45 parts by weight of a phenol novolak type cyanate ester resin (Primaset PT-30, supplied by LONZA). Table 3 shows the results of measurements of physical properties of the copper-clad laminate.

**Table 3**

| (Table 3) | Example 3 | Comparative Example 6 | Comparative Example 7 |
|---|---|---|---|
| Glass transition temperature (°C) | 305 | 260 | 250 |
| Heat resistance after moisture absorption | 0/3 | 0/3 | 2/3 |
| Copper foil peeling strength | 0.9 | 0.8 | 0.8 |

### (Example 4)

50 parts by weight of 3,3-bis(4-cyanatophenyl)-1 (3H) -isobenzofuranone obtained in Synthetic Example 1 and 50 parts by weight of a biphenyl aralkyl type epoxy resin (NC3000-H, supplied by Nippon Kayaku Co., Ltd.) were dissolved in methyl ethyl ketone. Further, 100 parts by weight of a spherical synthetic silica (SC-2050, supplied by ADMATECHS CO., LTD) and 0.04 part by weight of zinc octylate was mixed with the resultant solution to obtain a varnish. The varnish was diluted with methyl ethyl ketone. The diluted varnish was impregnated into an E glass cloth having a thickness of 0.1 mm. The impregnated varnish was dried under heat at 165 °C for 6 minutes, thereby obtaining prepregs having a resin content of 45 % by weight. Four prepregs obtained above were stacked and 12µm-thick electrolytic copper foils were placed on the upper and lower surfaces of the stack of the prepregs, one copper foil on the upper surface and one copper foil on the lower surface, and the prepregs and the copper foils were pressed at a pressure of 30 kgf/cm² at a temperature of 220 °C for 120 minutes, thereby obtaining a copper-clad laminate having a thickness of 0.4 mm. Table 4 shows the results of measurements of physical properties of the copper-clad laminate.

### (Comparative Example 8)

A copper-clad laminate having a thickness of 0.4 mm was obtained in the same manner as in Example 4 except that 50 parts by weight of 3,3-bis(4-cyanatophenyl)-1(3H)-isobenzofuranone used in Example 4 was replaced with 50 parts by weight of a prepolymer of 2,2-bis(4-cyanatophenyl)propane (BT2070, supplied by Mitsubishi Gas Chemical Company, Inc.). Table 4 shows the results of measurements of physical properties of the copper-clad laminate.

### (Comparative Example 9)

A copper-clad laminate having a thickness of 0.4 mm was obtained in the same manner as in Example 4 except that 50 parts by weight of 3,3-bis(4-cyanatophenyl)-1(3H)-isobenzofuranone used in Example 4 was replaced with 50 parts by weight of a phenol novolak type cyanate ester resin (Primaset PT-30, supplied by LONZA). Table 4 shows the results of measurements of physical properties of the copper-clad laminate.

**Table 4**

| (Table 4) | Example 4 | Comparative Example 8 | Comparative Example 9 |
|---|---|---|---|
| Glass transition temperature | 287 | 258 | 294 |
| Heat resistance after moisture absorption | 1/4 | 2/4 | 3/4 |
| Burning resistance | V-0 | Burnt | V-0 |

### (Example 5)

30 parts by weight of 3,3-bis(4-cyanatophenyl)-1(3H)-isobenzofuranone obtained in Synthetic Example 1, 50 parts by weight of a biphenyl aralkyl type epoxy resin (NC3000-H, supplied by Nippon Kayaku Co., Ltd.) and 20 parts by weight of bis (4-maleimidophenyl)methane (BMI-H, supplied by K I KASEI KK) were dissolved in methyl ethyl ketone. Further, 100 parts by weight of a spherical synthetic silica (SC-2050, supplied by ADMATECHS CO., LTD) and 0.04 part by weight of zinc octylate were mixed with the resultant solution to obtain a varnish. The varnish was diluted with methyl ethyl ketone. The diluted varnish was impregnated into an E glass cloth having a thickness of 0.1 mm. The impregnated varnish was dried under heat at 165 °C for 14 minutes, thereby obtaining prepregs. Four prepregs obtained above were stacked and 12µm-thick electrolytic copper foils were placed on the upper and lower surfaces of the stack of the prepregs, one copper foil on the upper surface and one copper foil on the lower surface, and the prepregs and the copper foils were pressed at a pressure of 30 kgf/cm² at a temperature of 220 °C for 120 minutes, thereby obtaining a copper-clad laminate having a thickness of 0.4 mm. Table 5 shows the results of measurements of physical properties of the copper-clad laminate.

### (Comparative Example 10)

A copper-clad laminate having a thickness of 0.4 mm was obtained in the same manner as in Example 5 except that 30 parts by weight of 3,3-bis(4-cyanatophenyl)-1(3H)-isobenzofuranone used in Example 5 was replaced with 30 parts by weight of a prepolymer of 2,2-bis(4-cyanatophenyl)propane (BT2070, supplied by Mitsubishi Gas Chemical Company, Inc.). Table 5 shows the results of measurements of physical properties of the copper-clad laminate.

### (Comparative Example 11)

A copper-clad laminate having a thickness of 0.4 mm was obtained in the same manner as in Example 5 except that 30 parts by weight of 3,3-bis(4-cyanatophenyl)-1(3H)-isobenzofuranone used in Example 5 was replaced with 30 parts by weight of a phenol novolak type cyanate ester resin (Primaset PT-30, supplied by LONZA). Table 5 shows the results of measurements of physical properties of the copper-clad laminate.

### (Example 6)

15 parts by weight of 3,3-bis(4-cyanatophenyl)-1(3H)-isobenzofuranone obtained in Synthetic Example 1, 15 parts by weight of a phenol novolak type cyanate ester resin (Primaset PT-30, supplied by LONZA), 50 parts by weight of a biphenyl aralkyl type epoxy resin (NC3000-H, supplied by Nippon Kayaku Co., Ltd.) and 20 parts by weight of bis (4-maleimidophenyl) methane (BMI-H, supplied by K I KASEI KK) were dissolved in methyl ethyl ketone. Further, 100 parts by weight of a spherical synthetic silica (SC-2050, supplied by ADMATECHS CO., LTD) and 0.06 part by weight of zinc octylate were mixed with the resultant solution to obtain a varnish. The varnish was diluted with methyl ethyl ketone. The diluted varnish was impregnated into an E glass cloth having a thickness of 0.1 mm. The impregnated varnish was dried under heat at 165 °C for 5 minutes, thereby obtaining prepregs. Four prepregs obtained above were stacked and 12µm-thick electrolytic copper foils were placed on the upper and lower surfaces of the stack of the prepregs, one copper foil on the upper surface and one copper foil on the lower surface, and the prepregs and the copper foils were pressed at a pressure of 30 kgf/cm² at a temperature of 220 °C for 120 minutes, thereby obtaining a copper-clad laminate having a thickness of 0.4 mm. Table 6 shows the results of measurements of physical properties of the copper-clad laminate.

### (Comparative Example 12)

A copper-clad laminate having a thickness of 0.4 mm was obtained in the same manner as in Example 6 except that 15 parts by weight of 3,3-bis(4-cyanatophenyl)-1(3H)-isobenzofuranone used in Example 6 was replaced with 15 parts by weight of a prepolymer of 2,2-bis(4-cyanatophenyl)propane (BT2070, supplied by Mitsubishi Gas Chemical Company, Inc.). Table 6 shows the results of measurements of physical properties of the copper-clad laminate.

**Table 5**

| (Table 5) | Example 5 | Comparative Example 10 | Comparative Example 11 |
|---|---|---|---|
| Glass transition temperature (°C) | 278 | 269 | 287 |
| Heat resistance after moisture absorption | 0/4 | 0/4 | 2/4 |
| Burning resistance | V-1 | Burnt | V-1 |

**Table 6**

| (Table 6) | Example 6 | Comparative Example 12 |
|---|---|---|
| Glass transition temperature (°C) | 282 | 275 |
| Heat resistance after moisture absorption | 0/4 | 2/4 |
| Burning resistance | V-1 | Burnt |

### (Measurement methods)

### 1) Glass transition temperature (unit: °C)

Cast molded product : A specimen having a size of 5 mm x 5 mm x 3 mm was prepared. The specimen was measured for a glass transition temperature with a TMA device (TA Instrument type 2940) at a loading of 5 g at a temperature-increasing rate of 10 °C/min.

Laminate : Copper foils of a double-side copper-clad laminate were completely removed. Then, the resultant laminate was measured for a glass transition temperature by DMA method in conformity with JIS-K6481.

### 2) Bending elastic modulus (unit: GPa)

A specimen having a size of 10 mm x 50 mm x 2 mm was prepared. The specimen was measured for a bending elastic modulus with an autograph (supplied by SHIMADZU CORPORATION, AG5000B) at normal temperature in conformity with JIS-K6911.

### 3) Heat resistance after moisture absorption

A copper-clad laminate sample having a size of 50 mm x 50 mm was prepared. The entire copper foil of the sample other than a copper foil on the half of one surface of the sample was removed by etching, to prepare a specimen. The specimen was treated with a pressure cooker testing machine (supplied by Hirayama Manufacturing Corporation, PC-3 type) at 121 °C at 2 atmospheric pressure for 3 hours or 5 hours. Then, the specimen was immersed in solder at 260 °C for 30 seconds. Then, an appearance change was observed by visual observation (the number of swelled specimens/the number of tested specimens).

### 4) Burning resistance

Measured in conformity with a UL 94 vertical test method.

### 5) Copper foil peeling strength (unit : kgf/cm)

Measured in conformity with JIS-C6481.

## Claims

1. A resin composition containing
a cyanate ester resin component A comprising a cyanate ester compound represented by the formula (1) and/or an oligomer thereof, and
at least one component B selected from the group consisting of an epoxy resin and a maleimide compound.

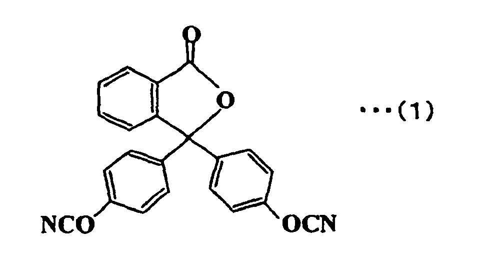

2. The resin composition according to claim 1, which further contains an inorganic filler.

3. The resin composition according to claim 1, wherein the component B comprises the epoxy resin or the epoxy resin and the maleimide compound.

4. The resin composition according to claim 3, wherein the epoxy resin is a non-halogen epoxy resin.

5. A cured product obtained by curing the resin composition as defined in claim 1.

6. A prepreg comprising the resin composition as defined in claim 3 and a base material.

7. A laminate obtained by curing the prepreg as defined in claim 6.

8. A metal-foil-clad laminate obtained by laminating the prepreg as defined in claim 6 and a metal foil and curing the prepreg with the metal foil.

## Patentansprüche

1. Harzzusammensetzung, enthaltend:
eine Cyanatesterharzkomponente A, umfassend eine Cyanatesterverbindung, dargestellt durch die Formel (1) und/oder ein Oligomer davon, und
mindestens eine Komponente B, ausgewählt aus der Gruppe, bestehend aus einem Epoxyharz und einer Maleimidverbindung

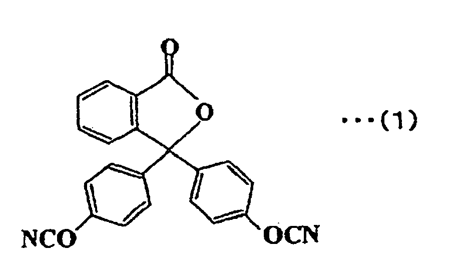

2. Harzzusammensetzung gemäß Anspruch 1, welche des Weiteren einen anorganischen Füllstoff enthält.

3. Harzzusammensetzung gemäß Anspruch 1, wobei die Komponente B das Epoxyharz, oder das Epoxyharz und die Maleimidverbindung umfasst.

4. Harzzusammensetzung gemäß Anspruch 3, wobei das Epoxyharz ein Nichthalogenepoxyharz ist.

5. Gehärtetes Produkt, erhalten durch Härten der Harzzusammensetzung, wie in Anspruch 1 definiert.

6. Prepreg, umfassend die Harzzusammensetzung wie in Anspruch 3 definiert und ein Basismaterial.

7. Laminat, erhalten durch Härten des Prepregs wie in Anspruch 6 definiert.

8. Metallfolie-Clad-Laminat, erhalten durch Laminieren des Prepregs wie in Anspruch 6 definiert und einer Metallfolie und Härten des Prepregs mit der Metallfolie.

## Revendications

1. Composition de résine contenant
- un composant A de résine d'ester cyanate représenté par la formule (1) et/ou un oligomère de celui-ci et
- au moins un composant B choisi parmi le groupe consistant en une résine époxyde et un composé d'amide maléique.

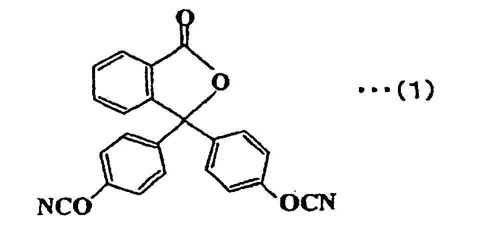

2. Composition de résine selon la revendication 1 contenant en outre une matière de remplissage inorganique.

3. Composition de résine selon la revendication 1, dans laquelle le composant B comprend la résine époxyde ou la résine époxyde et le composé d'amide maléique.

4. Composition de résine selon la revendication 3, dans laquelle la résine époxyde est une résine époxyde ne contenant pas d'halogène.

5. Produit durci qui est obtenu par durcissement de la composition de résine comme définie dans la revendication 1.

6. Préimprégné comprenant la composition de résine comme définie dans la revendication 3 et un matériau de base.

7. Stratifié obtenu par durcissement du préimprégné comme défini dans la revendication 6.

8. Stratifié comportant un plaquage fait d'un film métallique obtenu par stratification d'un préimprégné comme defini dans la revendication 6 et d'un film métallique et durcissement du préimprégné porteur du film métallique.
